(19) Europäisches Patentamt
European Patent Office
Office européen des brevets

(11) **EP 2 924 402 A1**

(12) **EUROPEAN PATENT APPLICATION**
published in accordance with Art. 153(4) EPC

(43) Date of publication:
**30.09.2015 Bulletin 2015/40**

(21) Application number: **13856270.7**

(22) Date of filing: **01.11.2013**

(51) Int Cl.:
*G01J 1/02* (2006.01)   *H01L 37/02* (2006.01)

(86) International application number:
**PCT/JP2013/006479**

(87) International publication number:
**WO 2014/080577 (30.05.2014 Gazette 2014/22)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: 26.11.2012   JP 2012257048
06.08.2013   JP 2013163011

(71) Applicant: **Panasonic Intellectual Property Management Co., Ltd.**
**Osaka-shi, Osaka 540-6207 (JP)**

(72) Inventors:
• **NODA, Toshinari**
  **Osaka 540-6207 (JP)**
• **KUBO, Takashi**
  **Osaka 540-6207 (JP)**
• **GAO, Anping**
  **Osaka 540-6207 (JP)**

(74) Representative: **Grünecker Patent- und Rechtsanwälte**
**PartG mbB**
**Leopoldstraße 4**
**80802 München (DE)**

(54) **INFRARED DETECTING DEVICE**

(57)   An infrared detecting device includes a substrate and a thermal photo detecting element. The substrate includes a concave portion, and a frame portion positioned on the periphery of the concave portion. The thermal photo detecting element includes leg portions and a detecting portion. The leg portions are connected on the frame portion so that the detecting portion is positioned above the concave portion. The thermal photo detecting element includes a first electrode layer disposed on the substrate, a detecting layer disposed on the first electrode layer, and a second electrode layer disposed on the detecting layer. The linear thermal expansion coefficient of the first electrode layer is larger than the linear thermal expansion coefficient of the substrate. The linear thermal expansion coefficient of the substrate is larger than the linear thermal expansion coefficient of the detecting layer.

FIG. 1B

**Description**

TECHNICAL FIELD

The present technical field relates to an infrared detecting device that detects electrical properties changing with a temperature rise in response to reception of infrared rays.

BACKGROUND ART

Conventionally, a thermal infrared detecting device using infrared rays is proposed as a sensor device for detecting a temperature in a non-contact manner. Examples of the thermal infrared detecting device include a pyroelectric detector, a resistance bolometer detector, and a thermopile detector. A pyroelectric detector uses a pyroelectric material that generates electric charges on the surface thereof in response to a temperature change. A resistance bolometer detector uses a resistance bolometer material whose resistance value changes in response to a temperature change. A thermopile detector employs the Seebeck effect that generates an electromotive force in response to a temperature difference.

Among these detectors, a pyroelectric detector has differential output characteristics, and generates an output in response to a change in the amount of incident infrared rays. Thus, a pyroelectric detector is widely used as a sensor, for example, for detecting the movement of an object generating heat, such as a human being and an animal.

As a pyroelectric detector, a detector of the single element type or the dual element type typically made of bulk ceramics is used (see Patent Literature 1, for example). For the dual element type detector, the light-receiving face electrodes of two single elements or the opposite face electrodes of the two single elements are connected in series so that the electric charges generated in response to a temperature change of the pyroelectric substrate are of opposite polarities. This configuration can correct the external temperature dependence caused when only one single element is used. The phase of the output waveform is inverted in response to the moving direction of a human being. Using this feature, depending on which of the human detection signal on the plus side or the minus side is output first, the moving direction of the human being can be determined.

However, in a conventional pyroelectric detector, it is difficult to sense a two-dimensional behavior of a human being in detail or to correctly sense the temperature distribution of a space.

Then, the following method is proposed to increase the number of pixels. A pyroelectric thin film formed on a silicon substrate is machined into an array shape by semiconductor micromachining process (see, Patent Literature 2 and Patent Literature3, for example).

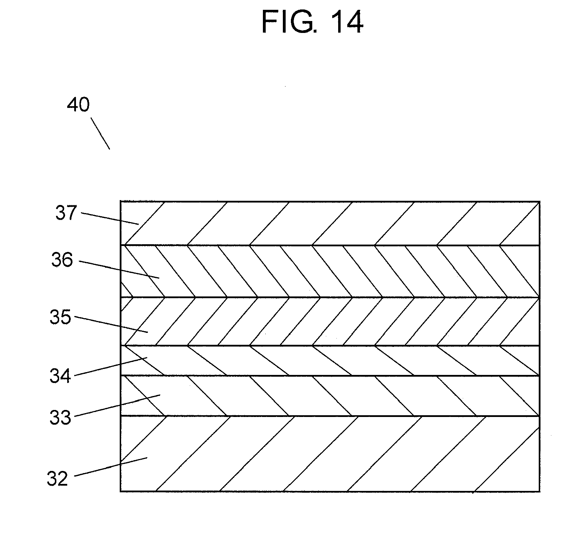

Fig. 14 is a sectional view of conventional pyroelectric infrared detecting device 40. Infrared detecting device 40 has $SiO_2$ layer 33, Ti layer 34, Pt layer 35, PLZT layer 36, and $IrO_2$ layer 37 formed on Si substrate 32 in this order from the Si substrate. PLZT layer 36 is formed of (Pb, La) (Zr, Ti) $O_3$. The thicknesses of Ti layer 34, Pt layer 35, PLZT layer 36, and $IrO_2$ layer 37 are approximately 20 nm, 100 nm, 200 nm, and 100 nm, respectively.

Ti layer 34 is provided as an adhesive layer that joins Pt layer 35 as a lower electrode and $SiO_2$ layer on Si substrate 32. Substantially, Ti layer 34 also functions as a lower electrode. PLZT layer 36 is a pyroelectric layer and is formed by a sol-gel method, RF sputtering method, metal-organic CVD (MOCVD) method, or the like. $IrO_2$ layer 37 functions as an upper electrode. $IrO_2$ layer 37 is formed by a reactive sputtering method, for example.

Citation List

Patent Literature

PTL1: International Publication No. WO 2011/001585
PTL2: International Publication No. WO 2004/079311
PTL3: Japanese Translation of PCT Publication No. 2010-540915

SUMMARY OF THE INVENTION

An infrared detecting device includes a substrate and a thermal photo detecting element. The substrate includes a concave portion, and a frame portion positioned on the periphery of the concave portion. The thermal photo detecting element includes leg portions and a detecting portion. The leg portions are connected on the frame portion so that the detecting portion is positioned above the concave portion. The thermal photo detecting element includes a first electrode layer disposed on the substrate, a detecting layer disposed on the first electrode layer, and a second electrode layer disposed on the detecting layer. The linear thermal expansion coefficient of the first electrode layer is larger than the linear thermal expansion coefficient of the substrate. The linear thermal expansion coefficient of the substrate is larger than the linear thermal expansion coefficient of the detecting layer.

BRIEF DESCRIPTION OF DRAWINGS

FIG. 1A is a top view of an infrared detecting device in accordance with a first exemplary embodiment.
FIG. 1B is a sectional view taken along line 1B-1B shown in FIG. 1A.
FIG. 2A is a top view of another infrared detecting device in accordance with the first exemplary embodiment.
FIG. 2B is a sectional view taken along line 2B-2B shown in FIG. 2A.
FIG. 3A is a top view of still another infrared detecting device in accordance with the first exemplary embodiment.
FIG. 3B is a sectional view taken along line 3B-3B shown in FIG. 3A.
FIG. 4 is a graph showing an X-ray diffraction pattern of a detecting layer in accordance with the first exemplary embodiment.
FIG. 5 is a graph showing characteristics of the detecting layer in accordance with the first exemplary embodiment.
FIG. 6A is a top view of an infrared detecting device in accordance with a second exemplary embodiment.
FIG. 6B is a sectional view taken along line 6B-6B shown in FIG. 6A.
FIG. 6C is a sectional view taken along line 6C-6C shown in FIG. 6A.
FIG. 6D is a sectional view taken along line 6D-6D shown in FIG. 6A.
FIG. 7 is a sectional view of another infrared detecting device in accordance with the second exemplary embodiment.
FIG. 8A is a top view of an infrared detecting device in accordance with a third exemplary embodiment.
FIG. 8B is a sectional view taken along line 8B-8B shown in FIG. 8A.
FIG. 9A is a top view of another infrared detecting device in accordance with the third exemplary embodiment.
FIG. 9B is a sectional view taken along line 9B-9B shown in FIG. 9A.
FIG. 9C is a sectional view taken along line 9C-9C shown in FIG. 9A.
FIG. 9D is a sectional view taken along line 9D-9D shown in FIG. 9A.
FIG. 10A is a top view of an infrared detecting device in accordance with a fourth exemplary embodiment.
FIG. 10B is a sectional view taken along line 10B-10B shown in FIG. 10A.
FIG. 11A is a top view of an infrared detecting device in accordance with a fourth exemplary embodiment.
FIG. 11B is a sectional view taken along line 11B-11B shown in FIG. 11A.
FIG. 11C is a sectional view taken along line 11C-11C shown in FIG. 11A.
FIG. 11D is a sectional view taken along line 11D-11D shown in FIG. 11A.
FIG. 12A is a top view of an infrared detecting device in accordance with a fifth exemplary embodiment.
FIG. 12B is a sectional view taken along line 12B-12B shown in FIG. 12A.
FIG. 13A is a top view of another infrared detecting device in accordance with the fifth exemplary embodiment.
FIG. 13B is a sectional view taken along line 13B-13B shown in FIG. 13A.
FIG. 13C is a sectional view taken along line 13C-13C shown in FIG. 13A.
FIG. 13D is a sectional view taken along line 13D-13D shown in FIG. 13A.
FIG. 14 is a sectional view of a conventional infrared detecting device.

DESCRIPTION OF EMBODIMENTS

In pyroelectric infrared detecting device 40 shown in FIG. 14, PLZT layer 36 having a larger linear thermal expansion coefficient is formed above Si substrate 32 having a smaller linear thermal expansion coefficient. Thus, a tensile stress is generated in PLZT layer 36 by a stress resulting from the difference in linear thermal expansion coefficient between Si substrate 32 and PLZT layer 36. As a result, PLZT layer 36 is preferentially oriented to the (100) plane, which is not a polarization axis. This can decrease the pyroelectric characteristics.

FIRST EXEMPLARY EMBODIMENT

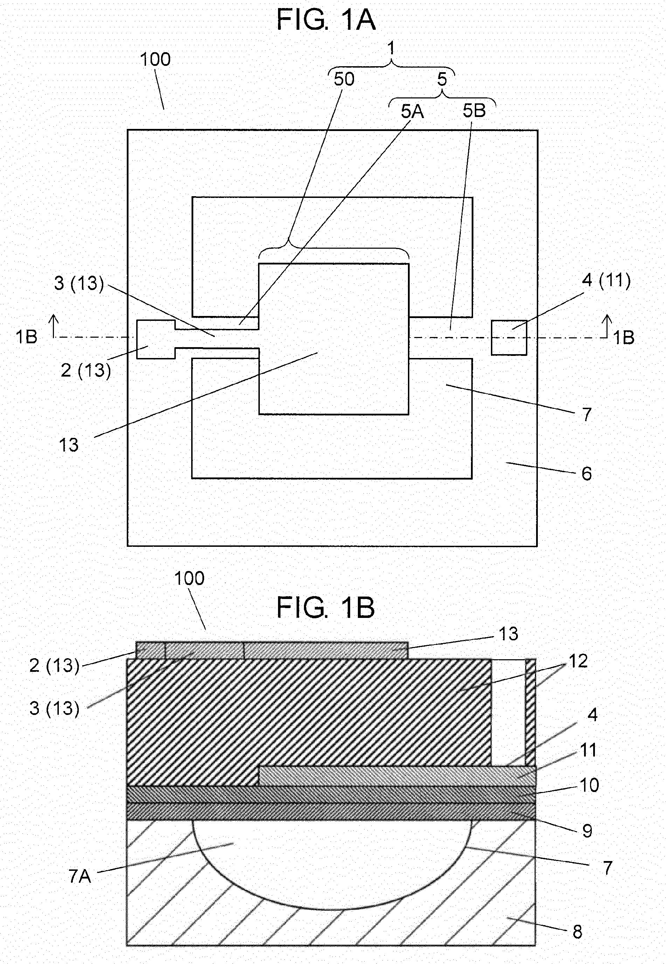

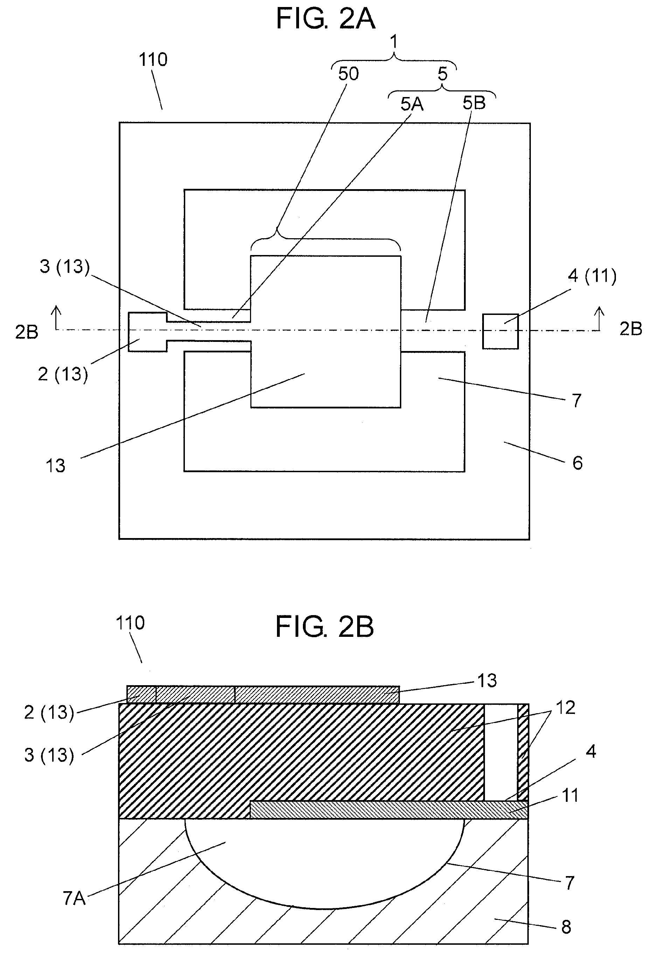

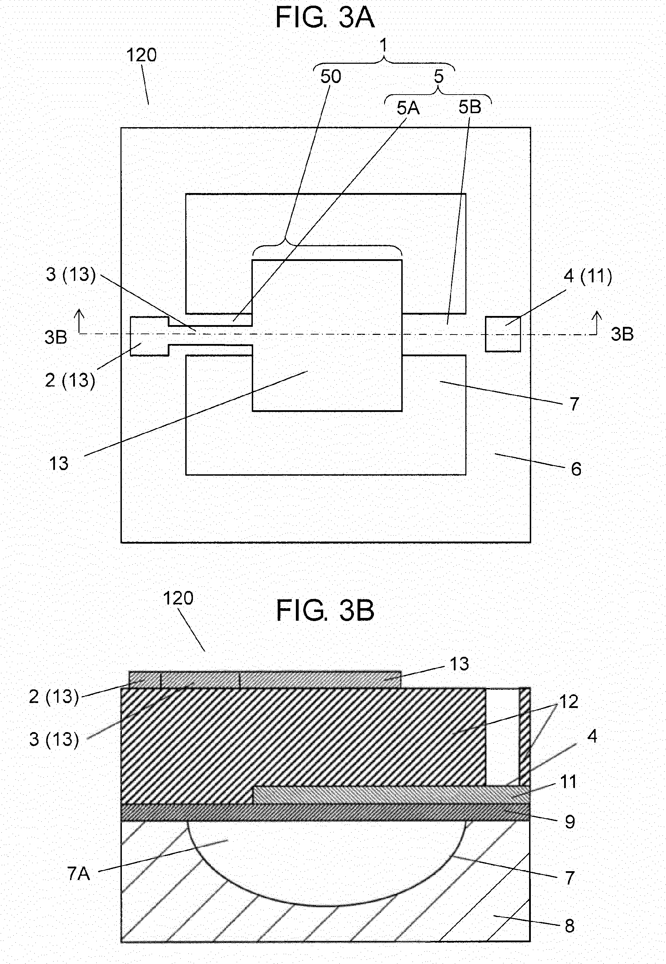

FIG. 1A is a top view of infrared detecting device 100 in accordance with the first exemplary embodiment. FIG. 1B is a sectional view taken along line 1B-1B shown in FIG. 1A. FIG. 2A is a top view of infrared detecting device 100 in accordance with the first exemplary embodiment. FIG. 2B is a sectional view taken along line 2B-2B shown in FIG. 2A. FIG. 3A is a top view of infrared detecting device 120 in accordance with the first exemplary embodiment. FIG. 3B is a sectional view taken along line 3B-3B shown in FIG. 3A.
Infrared detecting device 100 includes substrate 8 and thermal photo detecting element 1. Substrate 8 includes concave portion 7, and frame portion 6 positioned on the periphery of concave portion 7. Thermal photo detecting element 1 includes leg portions 5 and detecting portion 50. Leg portions 5 are connected on frame portion 6 so that detecting portion 50 is positioned above concave portion 7. Leg portions 5 are formed of leg portion 5A and leg portion 5B. Thermal photo detecting element 1 includes first intermediate layer 9 disposed on substrate 8 and above concave portion 7, and second intermediate layer 10 disposed on first intermediate layer 9. Further, thermal photo detecting element 1 includes first electrode layer 11 disposed on second intermediate layer 10, detecting layer 12 disposed on first electrode layer 11, and second electrode layer 13 disposed on detecting layer 12.

Next, each element is detailed. Substrate 8 has concave portion 7 at least one of principal planes. Leg portions 5A and 5B extend above concave portion 7 from the principal plane of substrate 8 that surrounds concave portion 7 (frame 6). Detecting portion 50 is suspended above concave portion 7 via leg portions 5A and 5B, and supported by the leg portions. Concave portion 7 allows thermal photo detecting element 1 to have a structure having high thermal insulation properties with respect to frame 6. Concave portion 7 has gap 7A therein. Concave portion 7 only needs to have a depth that allows thermal photo detecting element 1 to be supported above the hollow portion of substrate 8 by leg portions. Gap 7A may pass through substrate 8. Alternatively, as shown in FIG. 1B, bottomed concave portion 7 may be provided.

Detecting portion 50 is electrically connected to first electrode pad 4, i.e. part of first electrode layer 11. Under first electrode pad 4, first intermediate layer 9 and second intermediate layer 10 are laminated on principal plane 8 in this order from the principal plane. In first electrode pad 4, neither detecting layer 12 nor second electrode layer 13 are formed on first electrode layer 11.

Further, detecting portion 50 is electrically connected to second electrode pad 2 via electrical wiring 3 formed on leg portion 5. Under second electrode pad 2, first intermediate layer 9, second intermediate layer 10, and detecting layer 12 are formed on principal plane 8 in this order from the principal plane.

Substrate 8 has a linear thermal expansion coefficient larger than that of detecting layer 12. Examples of the materials for substrate 8 include the following substances: metal materials, such as ferritic stainless steel mainly made of iron and chromium, as well as titanium, aluminum, and magnesium; glass materials such as borosilicate glass; single crystal materials, such as magnesium oxide and calcium fluoride; and ceramic materials, such as titania and zirconia. In other words, as substrate 8, a material having a linear thermal expansion coefficient larger than that of detecting layer 12 can be used. Particularly when a material reflecting infrared rays is used, the infrared rays radiated to concave portion 7 can be reflected in the direction of thermal photo detecting element 1 and thus the infrared detection capability can be enhanced. Metal materials can strongly reflect infrared rays and are less expensive than silicon for the substrate.

As the material for substrate 8, a rolled steel tape (rolled steel sheet) may be used.

Substrate 8 is thicker than first intermediate layer 9, second intermediate layer 10, and first electrode layer 11. Thus, the residual stress in detecting layer 12 is considerably affected by the linear thermal expansion coefficient of substrate 8.

First intermediate layer 9 is made of silicon oxide or a compound material containing silicon oxide. Examples of the material for first intermediate layer 9 include silicon oxide, and a silicon nitride (SiON) thin film formed by nitriding silicon oxide.

Preferably, the element contained in substrate 8 is diffused into first intermediate layer 9. More preferably, at least two types of elements contained in substrate 8 are diffused into first intermediate layer 9. The amounts of diffusion (concentrations) of these two types of elements incline, i.e. decrease, from the side of substrate 8 toward the side of first electrode layer 11. For instance, when stainless steel is used as substrate 8, iron and chromium diffuse into first intermediate layer 9. In this case, chromium having a larger diffusion coefficient diffuses into first intermediate layer 9 more than iron having a smaller diffusion coefficient. That is, in first intermediate layer 9, the inclinations of two or more types of elements contained in substrate 8 are different. Thus, inside first intermediate layer 9, the ratio of the diffusion amount between iron and chromium is not 1: 1. As a result, the ratio of iron is larger on the side of substrate 8, and thus the linear thermal expansion coefficient on this side is larger. From the side of substrate 8 toward the side of first electrode layer 11, the linear thermal expansion coefficient decreases. This configuration can suppress the warp of substrate 8 and first intermediate layer 9 that is caused by the thermal stress resulting from the difference in linear thermal expansion coefficient between substrate 8 and first intermediate layer 9.

When elements other than iron and chromium are used as the elements diffused into first intermediate layer 9, the materials only need to be selected in consideration of the linear thermal expansion coefficients and diffusion coefficients. It is preferable to combine an element having a large linear thermal expansion coefficient and likely to diffuse and an element having a small linear thermal expansion coefficient and unlikely to diffuse.

A material mainly made of hafnium oxide is used as second intermediate layer 10. The linear thermal expansion coefficient of second intermediate layer 10 is larger than the linear thermal expansion coefficient of first intermediate layer 9 and smaller than the linear thermal expansion coefficient of detecting layer 12. If detecting layer 12 is formed directly on first intermediate layer 9, depending on the selected materials, a difference in linear thermal expansion coefficient can cause cracks or peeling of detecting layer 12. In order to prevent the cracks or peeling, it is preferable to form second intermediate layer 10 between first intermediate layer 9 and detecting layer 12. In the position where first electrode layer 11 is formed, preferably, second intermediate layer 10 is formed between first intermediate layer 9 and first electrode layer 11.

The material for second intermediate layer 10 is not limited to hafnium oxide. Any material having a linear thermal expansion coefficient larger than that of first intermediate layer 9 and smaller than that of detecting layer 12 may be used. Examples of the material include titanium oxide and aluminum oxide.

First intermediate layer 9 and second intermediate layer 10 are not indispensable elements and the following configurations may be used. As shown in FIG. 2A and 2B, it is not necessary to provide first intermediate layer 9 or second intermediate layer 10. Alternatively, as shown in FIG. 3A and FIG. 3B, second intermediate layer 10 is not provided and only first intermediate layer 9 is provided.

Also in the variations shown in FIG. 2A, 2B, 3A, and 3B, similarly to the configuration shown in FIG. 1A and FIG. 1B, the following advantages can be obtained. The linear thermal expansion coefficient of substrate 8 larger than that of detecting layer 12 allows a compressive stress to be applied to detecting layer 12. Further, when the residual stresses are released from detecting layer 12 and first electrode layer 11 by forming gap 7A, the linear thermal expansion coefficient of first electrode layer 11 larger than that of substrate 8 makes the stress releasing directions of both layers opposite to each other and thus allows the stresses to be cancelled out. This can suppress the warp or breakage of detecting layer 12.

Further, forming first intermediate layer 9 allows first electrode layer 11 to have high orientation and enhances the orientation of detecting layer 12. Forming second intermediate layer 10 allows a difference in linear thermal expansion coefficient between first intermediate layer 9 and detecting layer 12 to gradually change. This can further reduce the warp of substrate 8.

First electrode layer 11 is formed of lanthanum nickelate (LaNiO$_3$, hereinafter being referred to as "LNO"). LNO has a perovskite structure that has the space group R-3c and is distorted into a rhombohedron (rhombohedral system: $a_o$=0.5461 nm ($a_o$=$a_p$), $\alpha$=60°, pseudo-cubic system: $a_o$=0.384 nm). LNO is an oxide that has a resistivity of $1\times10^{-3}$ ($\Omega\cdot$cm, 300K) and metallic electrical conductivity. Further, even when the temperature is changed, transition between the metal and insulator does not occur.

The linear thermal expansion coefficient of first electrode layer 11 is larger than the linear thermal expansion coefficient of substrate 8. The linear thermal expansion coefficient of detecting layer 12 is smaller than the linear thermal expansion coefficient of substrate 8. Thus, the thermal stress applied to first electrode layer 11 by substrate 8 in film formation is in the tensile direction, and the thermal stress applied to detecting layer 12 by substrate 8 in film formation is in the compressive direction. Then, the direction of the residual stress in first electrode layer 11 and the direction of the residual stress in detecting layer 12 are cancelled out each other. This can suppress the breakage resulting from the warp and cracks of thermal photo detecting element 1 and leg portions 5 when concave portion 7 is formed on the surface of substrate 8 and the residual stresses are released. As a result, an infrared detecting device having high thermal insulation properties can be provided.

Preferably, detecting layer 12 has a perovskite structure containing lead titanate, and is formed of lead zirconate titanate (PZT) oriented to the (001) plane of a rhombohedral system or a tetragonal system. Preferably, the composition of PZT is in the vicinity of the composition of a tetragonal system Zr/Ti-30/70. PZT may have a composition (Zr/Ti=53/47) in the vicinity of the phase boundary between a tetragonal system and a rhombohedral system (the morphotropic phase boundary), and PbTiO$_3$ may be used. The composition only needs to be Zr/Ti=0/100 to 70/30. The material constituting detecting layer 12 may be a perovskite-type oxide ferroelectric material mainly made of PZT, such as PZT containing at least one of the following additives: La, Ca, Sr, Nb, Mg, Mn, Zn, and Al. That is, PMN-PT (Pb(Mg$_{1/3}$Nb$_{2/3}$)O$_3$-PbTiO$_3$) or PZN-PT (Pb(Zn$_{1/3}$Nb$_{2/3}$)O$_3$-PbTiO$_3$) may be used. A lead-free oxide ferroelectric material such as (Na, K)NbO$_3$ may also be used as detecting layer 12.

PZT of the tetragonal system used in this exemplary embodiment is a material having lattice constants of a=b=0.4036 nm and c=0.4146 nm in the form of the values of bulk ceramics. Thus, LNO having a pseudo-cubic structure with a lattice constant of a=0.384 nm has excellent lattice matching with the (001) plane and (100) plane of PZT. That is, first electrode layer 11 has excellent lattice matching with detecting layer 12.

Lattice matching means how well the lattices of two materials match each other. Generally when a type of crystal plane is exposed to the surface, a force is exerted so that the crystal lattice matches the crystal lattice of a film to be formed on the exposed surface. Thus, the epitaxial crystal cores are formed easily in the interface.

When the difference in lattice constant (lattice mismatch) between the (001) plane and (100) plane of detecting layer 12 and the main orientation plane of first electrode layer 11 is within approximately 10% in an absolute value, the orientation of either of the (001) plane or the (100) plane of detecting layer 12 can be enhanced. That is, it is preferable that the ratio of the difference in the lattice constant of the main orientation plane between first electrode layer 11 and detecting layer 12 with respect to the lattice constant of the main orientation plane of detecting layer 12 is within $\pm$ 10%.

Table 1 shows the preferential orientation plane and lattice constant of first electrode layer 11, the preferential orientation plane of detecting layer 12, and a difference in lattice constant (lattice mismatch) between the (001) plane and (100) plane of detecting layer 12 and the main orientation plane of first electrode layer 11 when various materials are used as first electrode layer 11.

The lattice mismatch shows the difference of the lattice constant of the c plane of the PZT thin film used as detecting layer 12 with respect to the lattice constant of first electrode layer 11 on a percentage basis. Also this result shows that the use of first electrode layer 11 having excellent lattice matching can set the preferential orientation plane of detecting layer 12 to the (001)/(100) plane.

[Table 1]

| Material for first electrode layer | LaNiO$_3$ | (La, Sr) CoO$_3$ | (La, Sr) MnO$_3$ | SrRuO$_3$ | Pt |
|---|---|---|---|---|---|
| Preferential orientation plane of first electrode layer | Pseudo-cubic (100) | Pseudo-cubic (100) | Pseudo-cubic (100) | Pseudo-cubic (100) | Cubic (100) |
| Lattice constant of first electrode layer | 3.84Å | 3.83Å | 3.87Å | 3.93Å | 3.92Å |
| Preferential orientation plane of detecting layer | (001)/(100) | (001)/(100) | (001)/(100) | (001)/(100) | (001)/(100) |
| Lattice mismatch | 7.97% | 8.25% | 7.13% | 5.50% | 5.77% |

In orientation control by lattice matching, it is difficult to fabricate a film of detecting layer 12 selectively oriented to either of the (001) plane or the (100) plane. However, in the process of forming detecting layer 12 to be described later, applying a stress to detecting layer 12 in the compressive direction can selectively orient detecting layer 12 to the (001) plane.

By the manufacturing method to be described later, LNO is preferentially oriented to the (100) plane on various types of substrates. Therefore, LNO not only works as first electrode layer 11 but also as the orientation control layer for detecting layer 12. This allows selective generation of the (001) plane or the (100) plane of PZT (lattice constant: a=0.4036 nm and c=0.4146 nm) that has excellent lattice matching with the surface of LNO oriented to the (100) plane (lattice constant: 0.384 nm).

In this exemplary embodiment, LNO is used as first electrode layer 11. Materials where part of nickel in lanthanum nickelate is replaced with other metals may also be used. Examples of such materials include LaNiO$_3$-LaFeO$_3$-based materials replaced with iron, LaNiO$_3$-LaAlO$_3$-based materials replaced with aluminum, LaNiO$_3$-LaMnO$_3$-based materials replaced with manganese, and LaNiO$_3$-LaCoO$_3$-based materials replaced with cobalt. As necessary, materials replaced with two or more metals may be used.

Further, as first electrode layer 11, a conductive oxide crystal may be used. Examples of the conductive oxide crystal include a perovskite-type oxide that is mainly made of strontium ruthenate, lanthanum-strontium-cobalt oxide, lanthanum-strontium-manganese oxide, or the like and is preferentially oriented to the (100) plane of a pseudo-cubic system. In other words, a perovskite-type oxide mainly made of lanthanum strontium cobaltate ((La, Sr)CoO$_3$), lanthanum strontium manganate ((La, Sr)MnO$_3$), or the like can be used. When these materials are used, the difference of the lattice constant of the c plane of detecting layer 12 with respect to the lattice constant of first electrode layer 11 can be maintained within 10%. This enhances the orientation of the (001) plane and (100) plane of detecting layer 12.

Second electrode layer 13 is formed of an alloy mainly made of nickel and chromium, and has electrical conductivity and a high infrared absorption capability among metal materials. The thickness of second electrode layer 13 is approximately 20 nm. The material for second electrode layer 13 is not limited to the alloy of nickel and chromium, and any material having electrical conductivity and infrared absorption capability may be used. Examples of the material for the second electrode layer include the following substances: titanium; titanium alloys; noble metal oxides, such as iridium oxide and ruthenium oxide; and conductive oxides, such as lanthanum nickelate, ruthenium oxide, and strontium ruthenate. Examples of the material also include metallic black films, i.e. so-called a platinum black film and a gold black film, in each of which the crystal grain sizes of platinum or gold are controlled so that infrared absorption capability is imparted.

As described above, the linear thermal expansion coefficient of substrate 8 is larger than the linear thermal expansion coefficient of detecting layer 12. In the film forming process of detecting layer 12 to be described later, an annealing step is necessary in film formation. PZT is crystallized and rearranged at high temperatures, and thus the difference in linear thermal expansion coefficient between PZT and substrate 8 makes a stress remain in PZT in cooling to room temperature. When SUS430, for example, is used as substrate 8, the linear thermal expansion coefficient of SUS430 is 10.5 ppm/K and that of PZT is 7.9 ppm/K. Thus, the linear thermal expansion coefficient of SUS430 is larger than that of PZT. Then, a stress in the compressive direction is applied to PZT. Therefore, detecting layer 12 has high selective orientation in the direction of the c axis, which is a polarization axis. SUS430, which corresponds to ISO No. 4016-430-00-I and the symbol X6Cr17 in international standards ISO 15510, is a material that is mainly made of iron and contains chromium in an amount ranging from 16 wt% to 18wt% inclusive.

It is known that the infrared detection capability of detecting layer 12 is proportional to the pyroelectric coefficient of the detecting layer. It is also known that the pyroelectric coefficient shows a high value in a film oriented in the polarization axis direction of the crystal. As described above, detecting layer 12 is formed above substrate 8 having a larger linear thermal expansion coefficient, and a compressive stress caused by a thermal stress is applied to the film in the film forming process. As a result, the detecting layer is oriented in the direction of the c axis as the polarization axis and has a high infrared detection capability.

Further, the compressive stress is applied to detecting layer 12 by the thermal stress from substrate 8. Thereby, the Curie point of detecting layer 12 can be enhanced. For instance, when detecting layer 12 is formed above a Si substrate, the Curie point is approximately 320°C. In contrast, when detecting layer 12 is formed above a SUS430 substrate, the Curie point considerably rises to approximately 380°C. Considerably raising the Curie point of detecting layer 12 in this manner can achieve high heat resistance and high heat resistance reliability. Thus, the present invention is applicable to the reflow process using lead-free solder, which is necessary for surface mounting, for example.

Leg portion 5A includes first intermediate layer 9, second intermediate layer 10 formed on first intermediate layer 9, detecting layer 12 formed on second intermediate layer 10, and second electrode layer 13 formed on detecting layer 12. Leg portion 5B includes first intermediate layer 9, second intermediate layer 10 formed on first intermediate layer 9, first electrode layer 11 formed on second intermediate layer 10, and detecting layer 12 formed on first intermediate layer 11. Detecting portion 50 includes first intermediate layer 9, second intermediate layer 10 formed on first intermediate layer 9, first electrode layer 11 formed on second intermediate layer 10, detecting layer 12 formed on first electrode layer 11, and second electrode layer 13 formed on detecting layer 12.

Next, a description is provided for a method for manufacturing infrared detecting device 100 in accordance with this exemplary embodiment. A silicon oxide precursor solution is applied, by the spin coat method, to the principal plane of substrate 8 in a planar shape before formation of concave portion 7, so that a silicon oxide precursor film is formed. Hereinafter, in the applied films, that is not in the crystallized state is referred to as a precursor film. Here, the solution used as the silicon oxide precursor solution is mainly made of tetraethoxysilane (TEOS, $Si(OC_2H_5)_4$). However, the precursor solution may be mainly made of methyltriethoxysilane (MTES, $CH_3Si(OC_2H_5)_3$), perhydropolysilazane (PHPS, $SiH_2NH$), or the like.

Next, the applied precursor solution is dried at temperatures ranging from 100°C to 300°C inclusive and thereafter heated at higher temperatures. Thereby, residual organic matter is thermally decomposed and the precursor film is densified. The series of operations from application of the silicon oxide precursor solution on substrate 8 to densification of the precursor solution are repeated plurality of times until the precursor film has a desired thickness. Thus, first intermediate layer 9 is formed.

When the precursor film is heated, iron and chromium as elements constituting substrate 8 are diffused into first intermediate layer 9. The linear thermal expansion coefficients of iron and chromium are larger than that of the silicon oxide that constitutes first intermediate layer 9. That is, the linear thermal expansion coefficient of the region where iron and chromium are diffused is larger than the linear thermal expansion coefficient of the silicon oxide as a simple substance. The amount of diffused iron and chromium into first intermediate layer 9 decreases from the side of substrate 8 toward first electrode layer 11. Further, chromium having a larger diffusion coefficient is diffused more into first intermediate layer 9 than iron having a smaller diffusion coefficient. Thus, in first intermediate layer 9, the linear thermal expansion coefficient gradually decreases from the side of substrate 8 toward the side of first electrode layer 11.

In this exemplary embodiment, the silicon oxide layer as first intermediate layer 9 is formed by a CSD method. However, the method for fabricating first intermediate layer 9 is not limited to the CSD method. Any method may be used as long as a silicon oxide precursor film is formed on substrate 8 and the silicon oxide is densified by heating.

Preferably, the thickness of first intermediate layer 9 ranges from 300 nm to 950 nm inclusive. When the thickness is smaller than 300 nm, both iron and chromium as the elements constituting substrate 8 diffuse into the whole of first intermediate layer 9 and can reach first electrode layer 11. When iron and chromium diffuse into first electrode layer 11, the crystallinity of LNO is decreased. When the thickness is larger than 950 nm, cracks, for example, can occur in first intermediate layer 9.

Next, a hafnium oxide precursor solution is applied on first intermediate layer 9 by the spin coat method so as to form a hafnium oxide precursor film. As the hafnium oxide precursor solution, a solution mainly made of hafnium alkoxide is used. Examples of the hafnium alkoxide include hafnium tetramethoxide ($Hf(OCH_3)_4$) and hafnium tetraisopropoxide ($Hf(OCH(CH_3)_2)_4$).

Next, the applied precursor solution is dried at temperatures ranging from 100°C to 300°C inclusive and thereafter heated at higher temperatures. Thereby, residual organic matter is thermally decomposed and the precursor film is densified. The series of operations from application of the hafnium oxide precursor solution on substrate 8 to densification of the precursor solution are repeated plurality of times until the precursor film has a desired thickness. Thus, second intermediate layer 10 is formed.

Next, an LNO precursor solution for forming first electrode layer 11 is applied above first intermediate layer 9 described above.

As the raw materials for the LNO precursor solution, lanthanum nitrate hexahydrate ($La(NO_3)_3 \cdot 6H_2O$) and nickel acetate tetrahydrate (($CH_3COO)_2Ni \cdot 4H_2O$) are used. As the solvent, 2-methoxy ethanol and 2-amino ethanol are used.

Next, the LNO precursor solution applied above the entire surface of substrate 8 is dried at temperatures ranging from 100°C to 300°C inclusive and thereafter heat-treated at higher temperatures. Thereby, residual organic components are thermally decomposed. The series of operations from application of the LNO precursor solution above first intermediate layer 9 to thermal decomposition are repeated plurality of times until the LNO precursor has a desired thickness. At the time when the LNO precursor film becomes a desired thickness, the film is rapidly heated using a rapid thermal annealing furnace (hereinafter being referred to as an "RTA furnace"). Thus, LNO is generated and crystallized. The conditions for crystallization are to densify first intermediate layer 9 and second intermediate layer 10 and to heat the precursor film for several minutes at a temperature equal to or higher than 600°C, which is higher than those of the heat treatment of the LNO precursor solution. The rate of temperature rise ranges from 100°C to 300°C inclusive per minute.

First electrode layer 11 is formed by the above procedure. Thereby, LNO oriented to the (100) plane is fabricated. In order to set first electrode layer 11 to a desired thickness, in place of collective crystallization after repeated operation from a plurality of times of application to thermal decomposition, the process from application to crystallization may be repeated.

After first electrode layer 11 has been formed, first electrode layer 11 is treated by a photolithography and etching process. A resist (not shown) is formed on first electrode layer 11, and exposed to ultraviolet rays using a chromium mask having a predetermined pattern, for example. Next, after the unexposed portion of the resist is removed using a developing solution so that a resist pattern is formed, first electrode layer 11 is patterned by dry etching. To pattern first electrode layer 11, various methods other than dry etching, such as wet etching, can be used.

Next, a description is provided for a method for manufacturing detecting layer 12. First, a PZT precursor solution is prepared and the prepared PZT precursor solution is applied on first electrode layer 11.

As the raw materials for the PZT precursor solution, lead acetate (II) trihydrate ($Pb(OCOCH_3)_2 \cdot 3H_2O$), titanium isopropoxide ($Ti(OCH(CH_3)_2)_4$), and zirconium normal propoxide ($Zr(OCH_2CH_2CH_3)_4$) are used. Ethanol is added to these materials to dissolve these materials, and the obtained solution is refluxed. Thus, the PZT precursor solution is prepared. The molar ratio between Ti and Zr is 70/30.

In this exemplary embodiment, the spin coat method is used as the application method. Other various application methods, such as a dip coat method and spray coat method, can be used.

After application of the PZT precursor solution has been completed, a wet PZT precursor film is formed by evaporating the solvent and hydrolysis. In order to remove the moisture and the residual solvent contained in this PZT precursor film, the wet PZT precursor film is dried in a drying furnace. Next, the PZT precursor film is temporarily baked in an electric furnace at temperatures higher than those of the drying furnace. In this exemplary embodiment, the PZT precursor film is formed by repeating the process from application of the PZT precursor solution to the temporary baking several times. Thereafter, in order to crystallize the PZT precursor film, the PZT precursor film is rapidly heated using an RTA furnace. The conditions for crystallization is to heat the PZT precursor film for several minutes at a temperature equal to or higher than 600°C, which is higher than those in temporary baking. The rate of temperature rise ranges from 100°C to 300°C inclusive per minute.

The thickness of detecting layer 12 formed in the above process ranges from approximately 50 nm to 400 nm inclusive. When the thickness larger than the above range is necessary, the process is repeated a plurality of times. In order to obtain a desired thickness, the following operation may be performed. The process of forming the PZT precursor film by applying the PZT precursor solution and drying the film is repeated a plurality of times. After the PZT precursor film having a desired thickness is formed, the crystallization process is performed collectively.

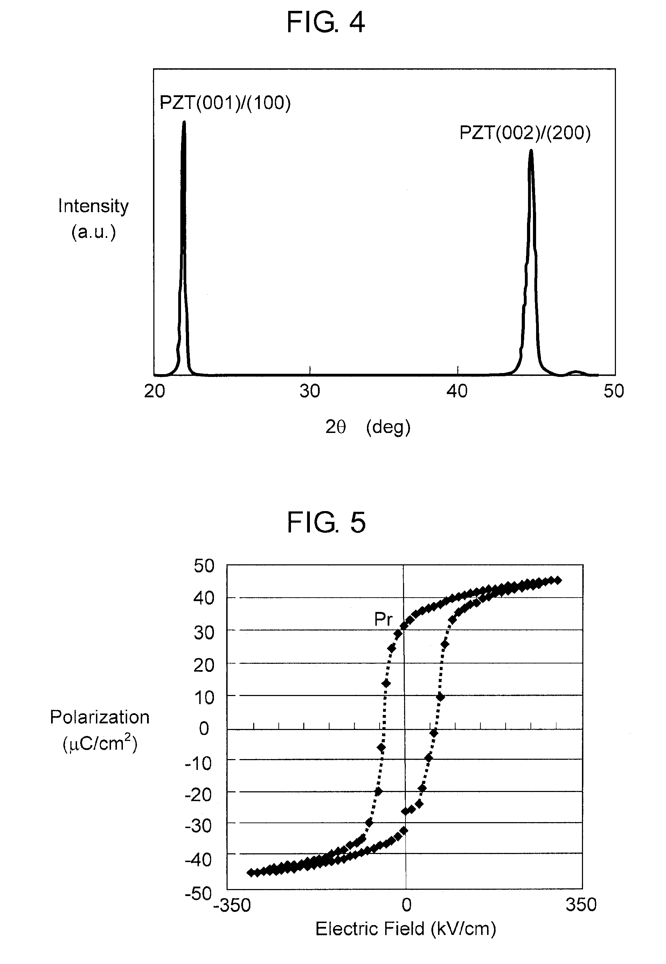

FIG. 4 shows a result of evaluating the crystallinity of detecting layer 12 by the X-ray diffraction method. For simple explanation, only major intensity peaks are shown. FIG. 4 shows that detecting layer 12 (PZT thin film) is preferentially oriented to the (001) plane.

FIG. 5 shows a measurement result of the characteristics (P-E hysteresis loop) of detecting layer 12 fabricated in accordance with this exemplary embodiment. The characteristics of detecting layer 12 show an excellent square-shaped loop and large residual polarization value Pr. The pyroelectric coefficient of detecting layer 12 is a coefficient obtained from a change in residual polarization value Pr caused by the temperature. In order to increase the pyroelectric coefficient, a large polarization value is important. Infrared detecting device 100 including detecting layer 12 can achieve the infrared detection capability higher than those of the conventional devices.

Second electrode layer 13 mainly made of nickel and chromium is formed, by a film forming method such as vacuum deposition, on detecting layer 12 formed by the above manufacturing method.

A film forming method that generates a small residual stress, such as vacuum deposition, is used in forming second electrode layer 13. Thereby, the breakage of leg portions 5 caused by the residual stress can be suppressed.

Further, even when the sputtering is used, bias application, for example, to the substrate can control the residual stress, thereby suppressing the breakage of leg portions 5 caused by the stress.

With the above process, a laminate film that includes first intermediate layer 9, second intermediate layer 10, first electrode layer 11, detecting layer 12, and second electrode layer 13 is formed on substrate 8 having no concave portion 7 formed therein, in this order from the principal plane of substrate 8.

Next, second electrode layer 13 and second electrode pad 2 are patterned by dry etching. Thereafter, detecting layer 12, first electrode layer 11, second intermediate layer 10, and first intermediate layer 9 are sequentially patterned by dry etching. The treatment process is similar to that of first electrode layer 11, and thus the detailed description is omitted.

Thereafter, wet etching is started from the portion where the surface of substrate 8 is exposed when viewed from the top. Thus, concave portion 7 is formed. Wet etching is performed until the back face of first intermediate layer 9 formed in thermal photo detecting element 1 and leg portions 5 is separated from the surface of substrate 8. This enhances the thermal insulation properties of infrared detecting device 100.

In this exemplary embodiment, first intermediate layer 9, second intermediate layer 10, first electrode layer 11, and detecting layer 12 are fabricated by the CSD method. This eliminates the need for the vacuum process necessary for the vapor phase growth method such as sputtering, thus reducing the cost. Further, LNO used as first electrode layer 11 can be self-oriented to the (100) plane by the manufacturing method of this exemplary embodiment. Thus, the orientation direction hardly depends on the material for substrate 8. This reduces the limitations on the materials for substrate 8.

When a metal material that reflects infrared rays, such as a stainless steel material, is used as substrate 8, the substrate reflects the infrared rays transmitted through thermal photo detecting element 1 and allows the reflected infrared rays to enter thermal photo detecting element 1 again. This can increase the amount of conversion from the incident infrared rays into heat, thus enhancing the infrared detection capability. Further, a stainless steel material is less expensive than silicon for the substrate, and thus the cost of the substrate can be reduced.

Since wet etching is used when substrate 8 is etched, the etching proceeds from the surface of substrate 8 isotropically. Thus, the treated shape of concave portion 7 is an arc shape when viewed from the sectional direction as shown in FIG. 1B. With this configuration, the etched bottom face works as a concave mirror for the infrared rays transmitted through thermal photo detecting element 1. This allows the infrared rays to be efficiently collected into thermal photo detecting element 1 from not only the upper side of second electrode layer 13 but also the lower side of first intermediate layer 9, i.e. the back side.

Further, it is preferable that a rolled stainless steel tape (rolled steel sheet) is used as the stainless steel material for substrate 8 and the stainless steel tape is formed of an aggregate of metal grains (metal structures) each having a diameter smaller than that of the material constituting detecting layer 12. When such a material is used as substrate 8, the etchant of wet etching penetrates from the grain boundaries of metal grains (metal structures). As a result, in the position under detecting layer 12 shown in the sectional view of FIG. 1B, etching of substrate 8 from the direction perpendicular to this section is promoted. This can increase the speed of the etching treatment of substrate 8, thus shortening the process of manufacturing the infrared detecting device.

When a stainless steel material is used as substrate 8, iron chloride solution, mixed acid solution, or the like can be used as the etchant.

When the exposed surface portion of substrate 8 is small in etching substrate 8, an etching hole (not shown) may be formed inside thermal photo detecting element 1 so that the etching hole passes through first intermediate layer 9, second intermediate layer 10, first electrode layer 11, detecting layer 12, and second electrode layer 13. This etching hole allows wet etching to be performed also from the inside of thermal photo detecting element 1, thus shortening the etching time.

The heating furnace for use in the crystallization process of first electrode layer 11 and detecting layer 12 of this exemplary embodiment is not limited to the RTA furnace, and an electric furnace, hot plate, IH heating furnace, laser annealing, or the like may be used.

SECOND EXEMPLARY EMBODIMENT

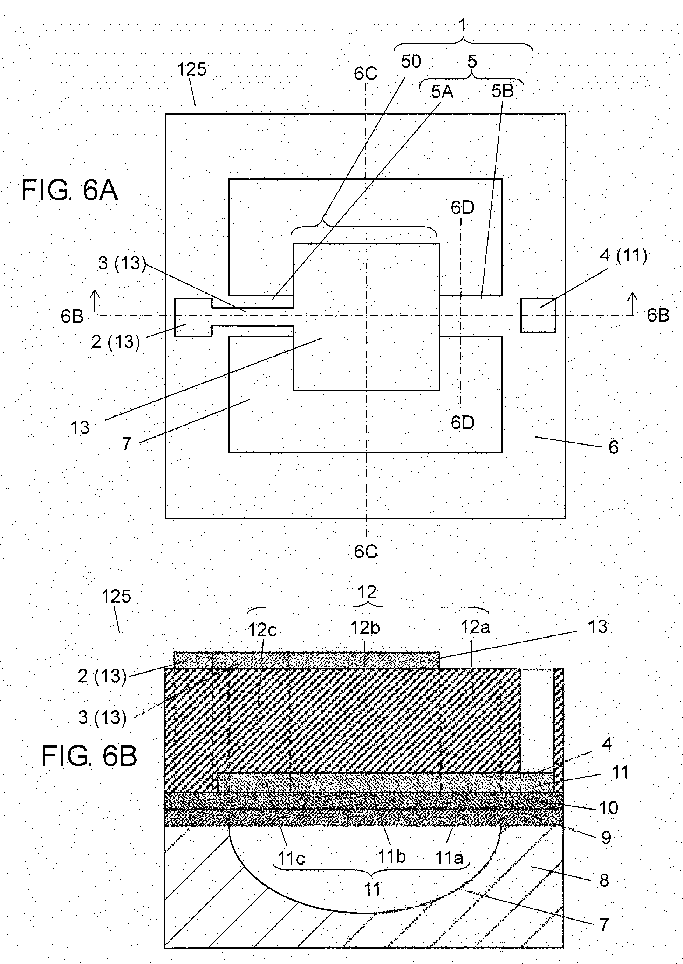

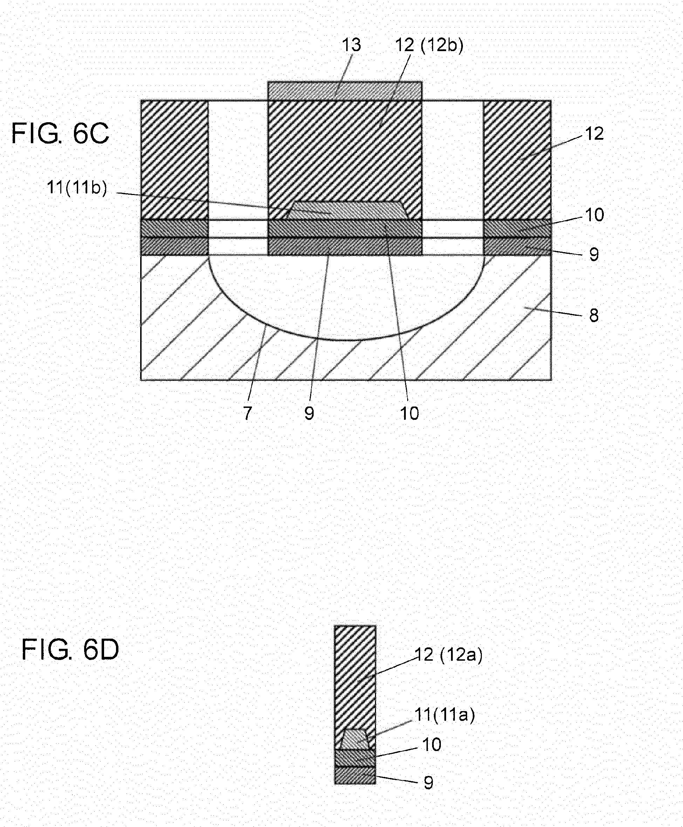

FIG. 6A is a top view of infrared detecting device 125 in accordance with the second exemplary embodiment. FIG. 6B is a sectional view taken along line 6B-6B shown in FIG. 6A. FIG. 6C is a sectional view taken along line 6C-6C shown in FIG. 6A. FIG. 6D is a sectional view taken along line 6D-6D shown in FIG. 6A. As shown in FIG. 6B, first electrode layer 11 that is formed under detecting layer 12 having no second electrode layer 13 formed thereon is defined as base portion 11a of first electrode layer 11. First electrode layer 11 that is formed under detecting layer 12 whose top surface is entirely covered with second electrode layer 13 is defined as main portion 11b of first electrode layer 11. First electrode layer 11 that is formed under detecting layer 12 whose top surface is partially covered with second electrode layer 13 is defined as extended portion 11c of first electrode layer 11.

Infrared detecting device 125 of this exemplary embodiment is different from infrared detecting device 100 of the first exemplary embodiment in that extended portion 11c of first electrode layer 11 is present. That is, in this exemplary embodiment, first electrode layer 11 is present also under detecting layer 12 whose top surface is partially covered with second electrode layer 13. Elements similar to those of the first exemplary embodiment have the same reference marks and the descriptions of those elements are omitted. The manufacturing method of this exemplary embodiment is the same as that of the first exemplary embodiment.

As shown in FIG. 6C, it is preferable that the width of main portion 11b of first electrode layer 11 is smaller than the width of detecting layer 12. As shown in FIG. 6D, it is preferable that the width of base portion 11a of first electrode layer 11 is smaller than the width of detecting layer 12. This shape is also applicable to extended portion 11c of first electrode layer 11. That is, it is preferable that the width of first electrode layer 11 is smaller than the width of detecting layer 12. In other words, in the width direction of first electrode layer 11, first electrode layer 11 is covered with detecting layer 12. First electrode layer 11 has a portion that is covered with detecting layer 12. Preferably, first electrode layer 11 is covered with detecting layer 12 except for first electrode pad 4, i.e. the portion from which an electrical signal is led out. Here, the width means the direction of line 6C-6C, i.e. line 6D-6D in FIG. 6A. Preferably, first electrode layer 11 is not exposed from the end face of detecting layer 12. Concave portion 7 is formed by the process of dissolving substrate 8 in iron chloride or mixed acid (e.g. wet etching). Conductive oxide materials used for first electrode layer 11, such as LNO, dissolve in acid. Thus, when substrate 8 is dissolved in iron chloride or mixed acid, first electrode layer 11 exposed to the end face of detecting layer 12 can also dissolve. Thus, it is preferable that the width of first electrode layer 11 is smaller than that of detecting layer 12 so that first electrode layer 11 is not exposed to the end face of thermal photo detecting element 1. This configuration can prevent first electrode layer 11 from being dissolved. As a result, infrared detecting device 125 having a high infrared detection capability can be obtained.

In other words, it is preferable that first electrode layer 11 is covered with detecting layer 12. That is, preferably, detecting layer 12 covers the face except the face where first electrode layer 11 is in contact with second intermediate layer 10 so that first electrode layer 11 is not exposed to the end face of thermal photo detecting element 1. For this purpose, it is preferable that the sectional shape perpendicular to the extending direction of first electrode layer 11 is made into a forward flared shape extending from detecting layer 12 toward second intermediate layer 10. When the sectional shape of first electrode layer 11 is a forward flared shape, the precursor solution of the PZT thin film is spin-coated on first electrode layer 11 along the flared faces. Thus, first electrode layer 11 is covered with detecting layer 12 without fail. By changing the conditions for dry etching, for example, first electrode layer 11 can be made into a forward flared shape.

In frame portion 6 of substrate 8 below second electrode layer 13, a region having first electrode layer 11 and an unformed region having no first electrode layer 11 are present. It is preferable that the layer below second electrode pad 2 is the unformed region where extended portion 11c of first electrode layer 11 is not formed. In this unformed region, second intermediate layer 10 and extended portion 12c of detecting layer 12 join together. This can inhibit formation of a capacitor structure in the portion where second electrode pad 2 is formed. The above configuration prevents generation of parasitic capacitance, thus enhancing the sensitivity of infrared detecting device 125.

Preferably, in leg portion 5A, extended portion 11c of first electrode layer 11 and second electrode layer 13 are not in the same plane in the vertical section of substrate 8. That is, extended portion 11c of first electrode layer 11 is not aligned with second electrode layer 13 when viewed from the top. This configuration can reduce the parasitic capacitance between wirings, thus further enhancing the sensor sensitivity of infrared detecting device 125.

The width of extended portion 11c of first electrode layer 11 is smaller than that of second electrode layer 13. This can reduce the parasitic capacitance generated between the extended portion and second electrode layer 13. As a result, the sensor sensitivity of infrared detecting device 125 is enhanced.

Base portion 11a, main portion 11b, and extended portion 11c of first electrode layer 11 may be formed of different materials that have linear thermal expansion coefficients larger than that of substrate 8. However, base portion 11a, main portion 11b, and extended portion 11c of first electrode layer 11 made of the same material can be collectively formed, thus enhancing the productivity. When the same material is used, the linear thermal expansion coefficient in all the portions of first electrode layer 11 is larger than the linear thermal expansion coefficient of substrate 8. Thus, the thermal stress applied from substrate 8 to all the portions of first electrode layer 11 in film formation is in the tensile direction. The thermal stress applied from substrate 8 to extended portion 11c of detecting layer 12 in film formation is in the compressive direction. Thus, the direction of the residual stress in first electrode layer 11 and the direction of the residual stress in detecting layer 12 are cancelled out each other. This can suppress the breakage caused by the warp or cracks of leg portions 5A and 5B when concave portion 7 is formed on the surface of substrate 8 and the residual stresses are released. As a result, an infrared detecting device having high thermal insulating properties can be achieved.

Detecting layer 12 that has no second electrode layer 13 formed thereon is defined as base portion 12a of detecting layer 12. Detecting layer 12 whose top surface is entirely covered with second electrode layer 13 is defined as main portion 12b of detecting layer 12. Detecting layer 12 whose top surface is partially covered with second electrode layer 13 is defined as extended portion 12c of detecting layer 12. Base portion 12a, main portion 12b, and extended portion 12c of detecting layer 12 may be formed of different materials that have linear thermal expansion coefficients smaller than that of substrate 8. However, base portion 12a, main portion 12b, and extended portion 12c made of the same material can be collectively formed, thus enhancing the productivity. When the material having a dielectric constant smaller than that of main portion 12b of detecting layer 12 is used in extended portion 12c of detecting layer 12, the parasitic capacitance between extended portion 11c of first electrode layer 11 and second electrode layer 13 can be reduced in leg portion 5A. As a result, the sensor sensitivity of the infrared detecting device can be enhanced. Preferably, lead zirconate titanate (PZT), for example, is used as main portion 12b, and alumina oxide, titanium oxide, zirconium oxide, hafnium oxide, or the like is used as extended portion 12c of detecting layer 12.

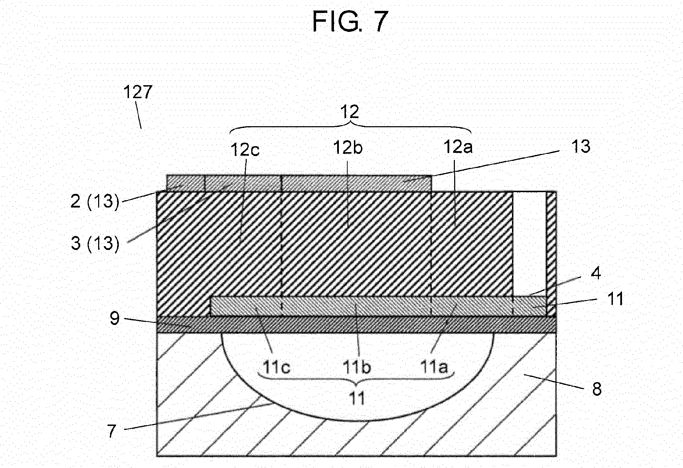

FIG. 7 is a sectional view of infrared detecting device 127 in accordance with the second exemplary embodiment. As shown in FIG.7, second intermediate layer 10 does not need to be provided.

THIRD EXEMPLARY EMBODIMENT

Hereinafter, a description is provided for infrared detecting device 130 in accordance with this exemplary embodiment with reference to the accompanying drawings. Elements similar to those of the first and second exemplary embodiments have the same reference marks and the descriptions of those elements are omitted.

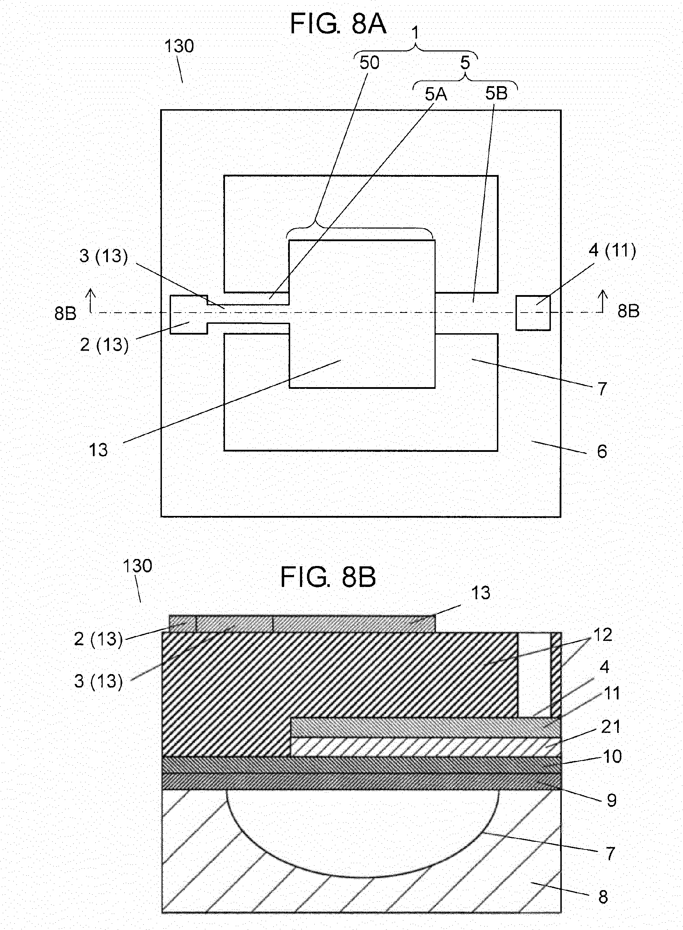

FIG. 8A is a top view of infrared detecting device 130 in accordance with the third exemplary embodiment. FIG. 8B is a sectional view taken along line 8B-8B shown in FIG. 8A. Infrared detecting device 130 of this exemplary embodiment is different from infrared detecting device 100 of the first exemplary embodiment in that first conductive layer 21 is formed between first electrode layer 11 and second intermediate layer 10.

Preferably, first conductive layer 21 is made of a material that has an electrical conductivity higher than that of first electrode layer 11 and reflects infrared rays. In this exemplary embodiment, a material mainly made of platinum (Pt) is used. The material for first conductive layer 21 is not limited to platinum, and the examples of the material include alloy materials such as a platinum-iridium alloy, gold, and gold alloys.

The Pt thin film used as first conductive layer 21 is made of a material easily oriented in the <111> direction in general. Thus, if detecting layer 12 made of PZT is formed directly on this thin film, the detecting layer is formed as a film that is preferentially oriented to the PZT (111) plane, which has excellent lattice matching with the Pt (111) plane. This decreases the infrared detection capability. However, in this exemplary embodiment, an LNO thin film as first electrode layer 11 is formed on first conductive layer 21, and thus a film preferentially oriented to the LNO (100) plane can be fabricated even above the Pt (111) plane. Thus, detecting layer 12 on first electrode layer 11 is a film preferentially oriented to the PZT (100) plane and can achieve a high infrared detection capability.

Forming first conductive layer 21 makes the electrical conductivity higher than that when only first electrode layer 11 is provided, thus enhancing the electrical characteristics of detecting layer 12. In particular, a value of dielectric loss tangent ($\tan\delta$), which is important in dielectric characteristics, can be decreased. This considerably reduces the noise in the infrared detecting device. As a result, the infrared detection capability is enhanced.

The thickness of first electrode layer 11 is defined as $d_{L1}$ and the refractive index thereof is defined as $n_{L1}$. The thickness of detecting layer 12 is defined as $d_{P1}$, the refractive index thereof is defined as $n_{P1}$. The wavelength of the infrared ray to be detected is defined as $\lambda_{P1}$. When $d_{L1}$ and $d_{P1}$ satisfy the following (Equation 1), the incident infrared ray interferes with the infrared ray reflected from first conductive layer 21 and thus a higher infrared absorption capability can be achieved. This enhances the infrared detection capability.

[Numerical Expression 1]

$$(n_{L1} \times d_{L1}) + (n_{P1} \times d_{P1}) = (2m+1) \times \lambda_{P1}/4 \quad (m=0, 1, 2, \ldots) \ldots (\text{Equation 1})$$

In order to increase adhesion between first conductive layer 21 and second intermediate layer 10, an adhesive layer (not shown) formed of Ti, $TiO_2$, or the like may be disposed between first conductive layer 21 and second intermediate layer 10.

The use of infrared detecting device 130 of this exemplary embodiment can provide a device having a high infrared detection capability, such as an infrared sensor.

In this exemplary embodiment, first intermediate layer 9 and second intermediate layer 10 are provided, but first intermediate layer 9 and second intermediate layer 10 may be omitted.

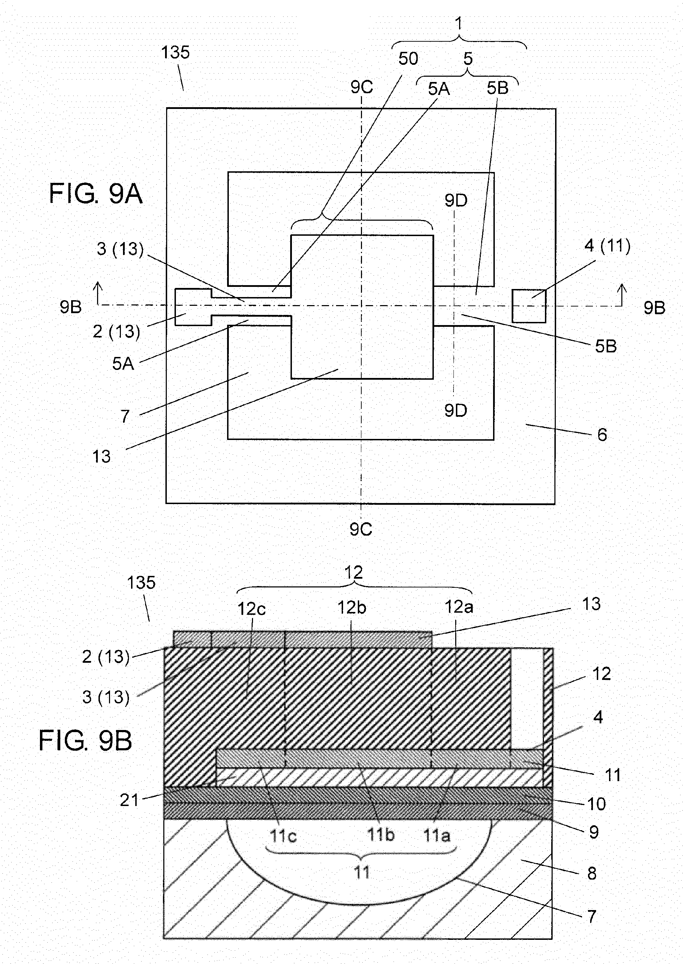

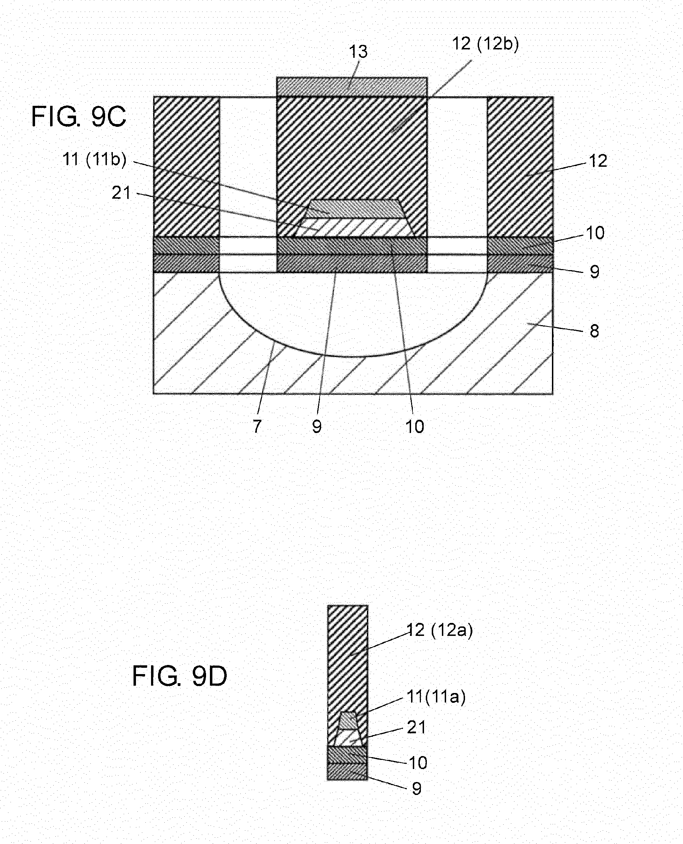

FIG. 9A is a top view of infrared detecting device 135 in accordance with the third exemplary embodiment. FIG. 9B is a sectional view taken along line 9B-9B shown in FIG. 9A. FIG. 9C is a sectional view taken along line 9C-9C shown in FIG. 9A. FIG. 9D is a sectional view taken along line 9D-9D shown in FIG. 9A. As shown in FIG. 9B, infrared detecting device 135 may include extended portion 11c of first electrode layer 11. That is, first electrode layer 11 may be present under detecting layer 12 whose top surface is partially covered with second electrode layer 13. Infrared detecting device 135 of this exemplary embodiment is different from infrared detecting device 125 of the second exemplary embodiment in that first conductive layer 21 is formed between first electrode layer 11 and second intermediate layer 10.

Base portion 11a, main portion 11b, and extended portion 11c of first electrode layer 11 may be made of the same material or different materials. As shown in FIG. 9C and FIG. 9D, it is preferable that first electrode layer 11 is not exposed from the end face of detecting layer 12. Further, it is preferable that first electrode layer 11 is covered with detecting layer 12. Thus, it is preferable that the sectional shape in the direction perpendicular to the extending direction of first electrode layer 11 is a forward flared shape extending from detecting layer 12 toward second intermediate layer 10.

FOURTH EXEMPLARY EMBODIMENT

Hereinafter, a description is provided for infrared detecting device 140 in this exemplary embodiment with reference to the accompanying drawings. Elements similar to those of the first and second exemplary embodiments have the same reference marks and the descriptions of those elements are omitted.

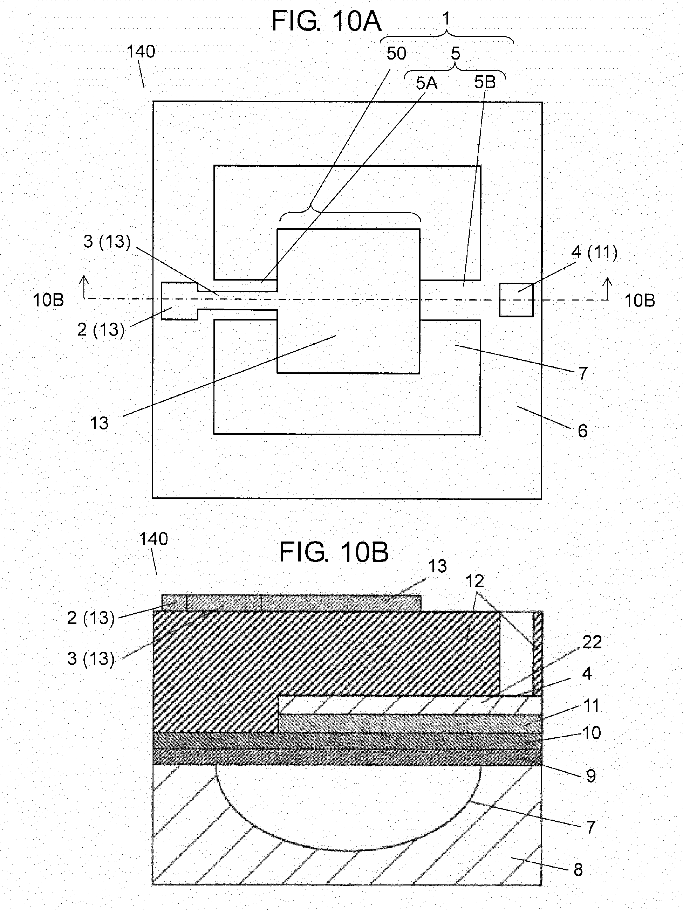

FIG. 10A is a top view of infrared detecting device 140 in accordance with the fourth exemplary embodiment. FIG. 10B is a sectional view taken along line 10B-10B shown in FIG. 10A.

Infrared detecting device 140 of this exemplary embodiment is different from infrared detecting device 100 of the first exemplary embodiment in that second conductive layer 22 is formed between first electrode layer 11 and detecting layer 12.

Preferably, second conductive layer 22 is made of a material that has an electrical conductivity higher than that of first electrode layer 11 and reflects infrared rays. In this exemplary embodiment, a material mainly made of platinum is used. The material for second conductive layer 22 is not limited to platinum, and examples of the material include alloy materials such as a platinum-iridium alloy, gold, and gold alloys.

The Pt thin film used as second conductive layer 22 is made of a material easily oriented in the <111> direction in general. Thus, when detecting layer 12 made of PZT is formed directly on this thin film, the detecting layer is formed as a film that is preferentially oriented to the PZT (111) plane, which has excellent lattice matching with the Pt (111) plane. This decreases the infrared detection capability.

In this exemplary embodiment, the Pt thin film is fabricated on first electrode layer 11 made of the LNO thin film having a high degree of orientation in the <100> direction. Thus, by controlling the sputtering film-forming conditions, second conductive layer 22 can be formed so as to be preferentially oriented to the Pt (100) plane, which has excellent lattice matching with the LNO (100) plane. This makes detecting layer 12 formed on second conductive layer 22 a film preferentially oriented to the PZT (001) plane, which has excellent lattice matching with the Pt (100) plane. Therefore, an excellent infrared detection capability can be achieved.

Forming second conductive layer 22 makes the electrical conductivity higher than that when only first electrode layer 11 is provided, thus enhancing the electrical characteristics of detecting layer 12. In particular, a value of dielectric loss tangent (tan$\delta$), which is important in dielectric characteristics, can be decreased. This considerably reduces the noise in the infrared detecting device. As a result, the infrared detection capability is enhanced.

The thickness of detecting layer 12 is defined as $d_{P2}$ and the refractive index thereof is defined as $n_{P2}$. The wavelength of the infrared ray to be detected is defined as $\lambda_{P2}$. When $d_{P2}$ satisfies the following (Equation 2), the incident infrared ray interferes with the infrared ray reflected from second conductive layer 22 and thus a higher infrared absorption capability can be achieved. This can enhance the infrared detection capability.

[Numerical Expression 2]

$$n_{P2} \times d_{P2} = (2m+1) \times \lambda_{P2}/4 \quad (m=0, 1, 2, \ldots) \ldots (\text{Equation 2})$$

The use of infrared detecting device 140 of this exemplary embodiment can provide a device having a high infrared detection capability, such as an infrared sensor.

In this exemplary embodiment, first intermediate layer 9 and second intermediate layer 10 are provided, but first intermediate layer 9 and second intermediate layer 10 may be omitted.

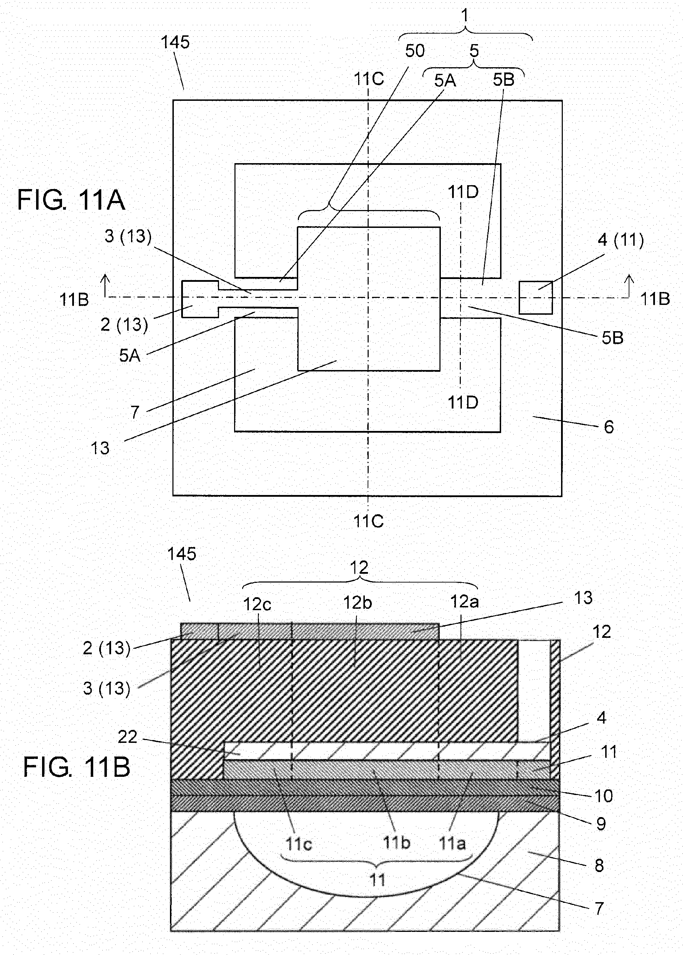

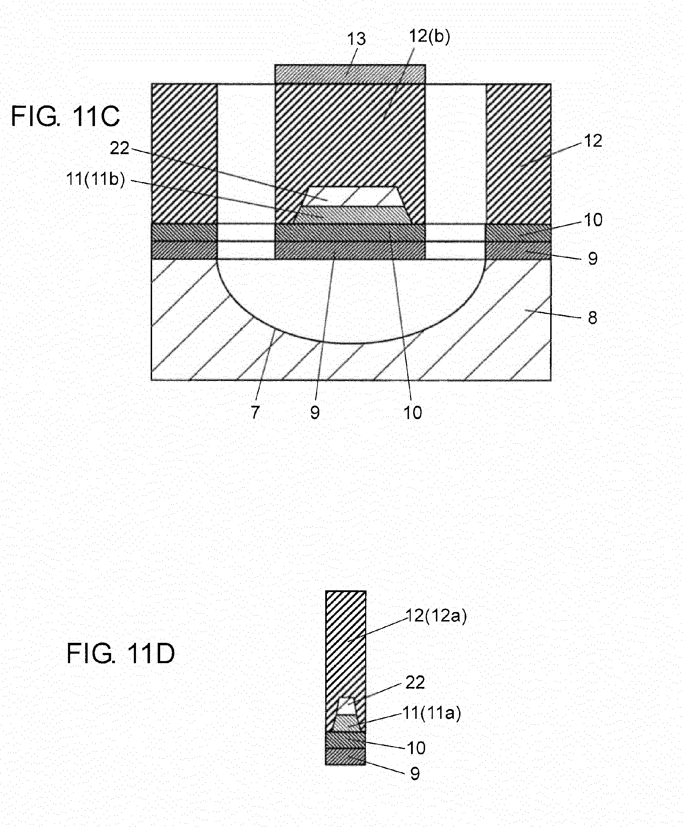

FIG. 11A is a top view of infrared detecting device 145 in accordance with the fourth exemplary embodiment. FIG. 11B is a sectional view taken along line 11B-11B shown in FIG. 11A. FIG. 11C is a sectional view taken along line 11C-11C shown in FIG. 11A. FIG. 11D is a sectional view taken along line 11D-11D shown in FIG. 11A. As shown in FIG. 11B, infrared detecting device 145 may include extended portion 11c of first electrode layer 11. That is, first electrode layer 11 may be present under detecting layer 12 whose top surface is partially covered with second electrode layer 13. Infrared detecting device 145 of this exemplary embodiment is different from infrared detecting device 125 of the second exemplary embodiment in that second conductive layer 22 is formed between first electrode layer 11 and detecting layer 12.

Base portion 11a, main portion 11b, and extended portion 11c of first electrode layer 11 may be made of the same material or different materials. As shown in FIG. 11C and FIG. 11D, it is preferable that first electrode layer 11 is not exposed from the end face of detecting layer 12. Further, it is preferable that first electrode layer 11 is covered with detecting layer 12. Thus, it is preferable that the sectional shape in the direction perpendicular to the extending direction of first electrode layer 11 is a forward flared shape extending from detecting layer 12 toward second intermediate layer 10.

In the fourth exemplary embodiment, second conductive layer 22 is used as first electrode pad 4.

FIFTH EXEMPLARY EMBODIMENT

Hereinafter, a description is provided for infrared detecting device 150 in accordance with the fifth exemplary embodiment with reference to the accompanying drawings. Elements similar to those of the first and second exemplary embodiments have the same reference marks and the descriptions of those elements are omitted.

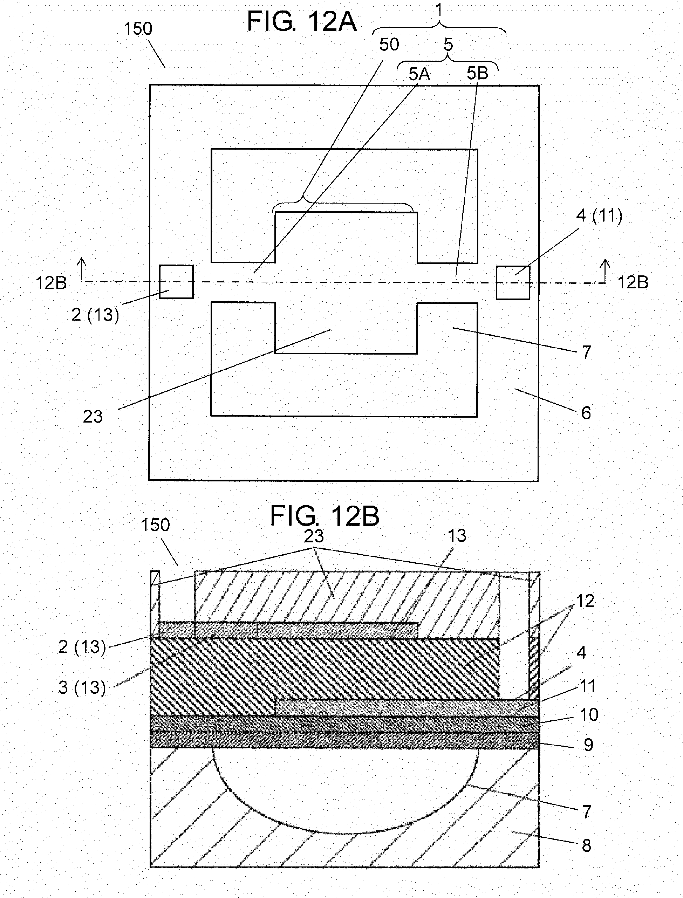

FIG. 12A is a top view of infrared detecting device 150 in accordance with the fifth exemplary embodiment. FIG. 12B is a sectional view taken along line 12B-12B shown in FIG. 12A.

Infrared detecting device 150 of this exemplary embodiment is different from infrared detecting device 100 of the first exemplary embodiment in that infrared absorbing layer 23 is formed on detecting layer 12 and second electrode layer 13.

Preferably, infrared absorbing layer 23 is made of a material that has a liner thermal expansion coefficient smaller than that of detecting layer 12 and absorbs infrared rays. In this exemplary embodiment, a material mainly made of silicon oxide is used. The material for infrared absorbing layer 23 is not limited to silicon oxide, and any material that has a linear thermal expansion coefficient smaller than that of detecting layer 12 and absorbs infrared rays may be used. Other examples include a silicon oxide nitride (SiON) film formed by nitriding silicon oxide, and a silicon nitride (SiN) film.

Infrared absorbing layer 23 can suppress the release of the compressive stress applied to detecting layer 12 while wet etching is performed from the surface of substrate 8, concave portion 7 is formed, and detecting layer 12 is separated from substrate 8. Since infrared absorbing layer 23 has a linear thermal expansion coefficient smaller than that of detecting layer 12, infrared absorbing layer 23 undergoes a stress relatively in the tensile direction in comparison with detecting layer 12. That is, when detecting layer 12 is separated from substrate 8, detecting layer 12 under the stress in the compressive direction undergoes a force in the tensile direction along which the stress is released. In contrast, infrared absorbing layer 23 formed on the detecting layer undergoes a force relatively in the compressive direction, which is opposite to the direction in detecting layer 12. Thus, the release of the stress in detecting layer 12 is suppressed. This allows high polarizing characteristics of detecting layer 12 to be maintained and can suppress a decrease in the Curie point that has been enhanced by the compressive stress.

Further, since infrared absorbing layer 23 has the infrared absorption capability, the infrared absorbing layer is capable of efficiently converting the received infrared rays into heat, thus achieving a high infrared detection capability. Further, second electrode layer 13 that is made of a material reflecting infrared rays, such as gold and platinum, can achieve a higher infrared adsorption capability because the infrared rays transmitted through infrared absorbing layer 23 once reflect from second electrode layer 13 and are absorbed by infrared absorbing layer 23 again. As a result, a higher infrared detection capability can be achieved.

The thickness of infrared absorbing layer 23 is defined as ds and the refractive index thereof is defined as ns, and the wavelength of the infrared ray to be detected is defined as $\lambda_S$. Preferably, ds satisfies (Equation 3), where m is equal to 0 or a natural number. In this case, the incident infrared ray interferes with the infrared ray reflected from second conductive layer 13 and thus the higher infrared absorption capability can be achieved. This enhances the infrared detection capability.

[Numerical Expression 3]

$$n_S \times d_S = (2m+1) \times \lambda_S/4 \quad (m=0, 1, 2, \ldots) \ldots(\text{Equation 3})$$

The use of infrared detecting device 150 of this exemplary embodiment can provide a device having a high infrared detection capability, such as an infrared sensor.

In this exemplary embodiment, first intermediate layer 9 and second intermediate layer 10 are provided, but first intermediate layer 9 and second intermediate layer 10 may be omitted.

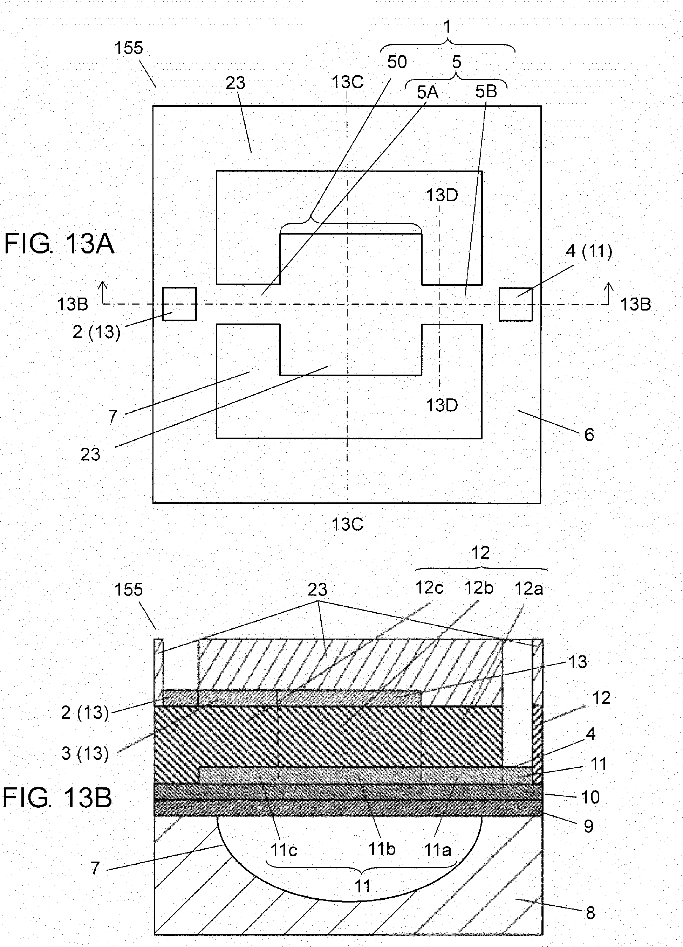

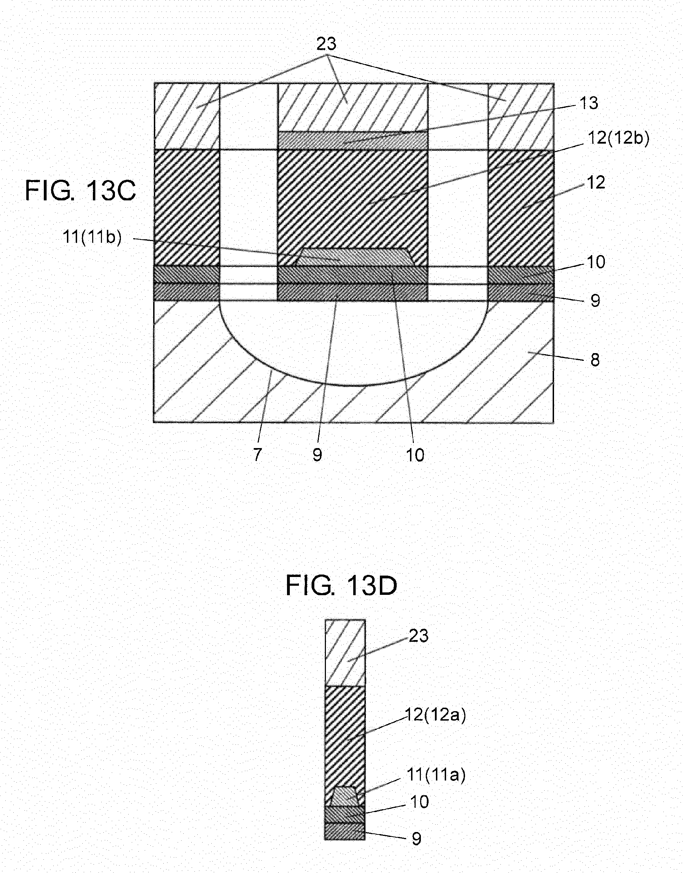

FIG. 13A is a top view of infrared detecting device 155 in accordance with the fifth exemplary embodiment. FIG. 13B is a sectional view taken along line 13B-13B shown in FIG. 13A. FIG. 13C is a sectional view taken along line 13C-13C shown in FIG. 13A. FIG. 13D is a sectional view taken along line 13D-13D shown in FIG. 13A. As shown in FIG. 13B, infrared detecting device 155 may have extended portion 11c of first electrode layer 11. That is, first electrode layer 11 may be present under detecting layer 12 whose top surface is partially covered with second electrode layer 13.

Infrared detecting device 155 of this exemplary embodiment is different from infrared detecting device 125 of the second exemplary embodiment in that infrared absorbing layer 23 is formed on detecting layer 12 and second electrode layer 13.

Base portion 11a, main portion 11b, and extended portion 11c of first electrode layer 11 may be made of the same material or different materials. As shown in FIG. 13C and FIG. 13D, it is preferable that first electrode layer 11 is not exposed from the end face of detecting layer 12. Further, it is preferable that first electrode layer 11 is covered with detecting layer 12. Thus, it is preferable that the sectional shape in the direction perpendicular to the extending direction of first electrode layer 11 is a forward flared shape extending from detecting layer 12 toward second intermediate layer 10.

As described in this exemplary embodiment, substrate 8 having a linear thermal expansion coefficient larger than that of detecting layer 12 is used. Thus, a compressive stress can be applied to detecting layer 12 by a thermal stress. As a result, a high infrared detection capability can be achieved.

Further, since the linear thermal expansion coefficient of first electrode layer 11 is larger than the linear thermal expansion coefficient of substrate 8, the stress in first electrode layer 11 and the stress in detecting layer 12 are cancelled out each other. Thus, even in an infrared detecting device structured to have high thermal insulating properties and to support detecting layer 12 with thin leg portions, the warp and breakage of detecting layer 12 can be suppressed. As a result, an infrared detecting device having a high infrared detection capability can be achieved.

INDUSTRIAL APPLICABILITY

An infrared detecting device in accordance with the exemplary embodiments has high pyroelectric characteristics and high thermal insulating properties. This can provide excellent sensor characteristics having a high infrared detection capability. The use of the infrared detecting device in accordance with the exemplary embodiments in various types of electronic equipment is useful as various sensors such as a human detection sensor and a temperature detection sensor, and power generation devices such as a pyroelectric power generation device.

REFERENCE MARKS IN THE DRAWINGS

| | |
|---|---|
| 1 | Thermal photo detecting element |
| 2 | Second electrode pad |
| 3 | Electrical wiring |
| 4 | First electrode pad |
| 5, 5A, 5B | Leg portion |
| 6 | Frame portion |
| 7 | Concave portion |
| 7A | Gap |
| 8 | Substrate |
| 9 | First intermediate layer |
| 10 | Second intermediate layer |
| 11 | First electrode layer |
| 11a, 12a | Base portion |
| 11b, 12b | Main portion |
| 11c, 12c | Extended portion |
| 12 | Detecting layer |
| 13 | Second electrode layer |
| 21 | First conductive layer |
| 22 | Second conductive layer |
| 23 | Infrared absorbing layer |
| 50 | Detecting portion |
| 100, 110, 120, 125, 127, 130, 135, 140, 145, 150, 155 | Infrared detecting device |

**Claims**

1.  An infrared detecting device comprising:

    a substrate including a concave portion, and a frame portion positioned on a periphery of the concave portion; and
    a thermal photo detecting element including:

a leg portion;

a detecting portion, the leg portion being connected on the frame portion so that the detecting portion is positioned above the concave portion:

a first electrode layer disposed on the substrate;

a detecting layer disposed on the first electrode layer; and

a second electrode layer disposed on the detecting layer,

wherein a linear thermal expansion coefficient of the first electrode layer is larger than a linear thermal expansion coefficient of the substrate, and

the linear thermal expansion coefficient of the substrate is larger than a linear thermal expansion coefficient of the detecting layer.

2. The infrared detecting device of claim 1, further comprising a first intermediate layer at least at part between the substrate and the first electrode layer.

3. The infrared detecting device of claim 2, wherein an element contained in the substrate is diffused into the first intermediate layer.

4. The infrared detecting device of claim 2, wherein a linear thermal expansion coefficient of the first intermediate layer on a side of the substrate is larger than a linear thermal expansion coefficient of the first intermediate layer on a side of the first electrode layer.

5. The infrared detecting device of claim 2, wherein the first intermediate layer is mainly made of silicon oxide.

6. The infrared detecting device of claim 2, wherein in a width direction of the first electrode layer, the first electrode layer has a portion covered with the detecting layer.

7. The infrared detecting device of claim 2, wherein a section perpendicular to an extending direction of the first electrode layer has a forward flared shape extending from the detecting layer toward the substrate.

8. The infrared detecting device of claim 2, further comprising a second intermediate layer between the first intermediate layer and the detecting layer, wherein a linear thermal expansion coefficient of the second intermediate layer is larger than a linear thermal expansion coefficient of the first intermediate layer and smaller than the linear thermal expansion coefficient of the detecting layer.

9. The infrared detecting device of claim 8, wherein the second intermediate layer is formed of a material containing titanium oxide or hafnium oxide.

10. The infrared detecting device of claim 2, wherein a region having the first electrode layer formed therein and a region having the first electrode layer not formed therein are present in the frame portion of the substrate below the second electrode layer.

11. The infrared detecting device of claim 2, wherein part of the first electrode layer and part of the detecting layer are formed on the first intermediate layer.

12. The infrared detecting device of claim 1, further comprising a first conductive layer disposed between the first electrode layer and the substrate, and having an electrical conductivity higher than that of the first electrode layer.

13. The infrared detecting device of claim 1, further comprising a second conductive layer disposed between the first electrode layer and the detecting layer, and having an electrical conductivity higher than that of the first electrode layer.

14. The infrared detecting device of claim 13, wherein the second conductive layer is formed of a material that contains platinum whose main orientation plane is a (100) plane.

15. The infrared detecting device of claim 1, wherein an infrared absorbing layer having a linear expansion coefficient smaller than that of the detecting layer is formed on a surface of the detecting layer on a side opposite the first electrode layer.

**16.** The infrared detecting device of claim 1, wherein the substrate is made of a metal material.

**17.** The infrared detecting device of claim 1, wherein the concave portion is made of a material that reflects infrared rays.

**18.** The infrared detecting device of claim 1, wherein
the substrate is formed of a ferritic stainless steel material,
the first electrode layer is formed of a conductive oxide material that has a perovskite structure and is mainly made of one of lanthanum nickelate, lanthanum strontium cobaltate, and lanthanum strontium manganate, and
the detecting layer is formed of a pyroelectric material having a perovskite structure and containing lead titanate.

**19.** The infrared detecting device of claim 1, wherein part of the first electrode layer and part of the detecting layer are formed on the substrate.

# FIG. 1A

# FIG. 1B

# FIG. 2A

# FIG. 2B

## FIG. 3A

## FIG. 3B

# FIG. 4

# FIG. 5

FIG. 6A

125

1
50
5
5A
5B
6C
6D
3 (13)
2 (13)
6B
6B
13
7
6C
6D
6

FIG. 6B

125
12
12c
12b
12a
13
2 (13)
3 (13)
4
11
10
9
11c
11b
11a
8
11
7

FIG. 6C

13    12 (12b)

11(11b)

12

10

9

8

7    9    10

FIG. 6D

12 (12a)

11(11a)

10

9

# FIG. 7

## FIG. 8A

## FIG. 8B

FIG. 9A

FIG. 9B

FIG. 9C

13

12 (12b)

11 (11b)

21

12

10

9

8

7    9    10

FIG. 9D

12 (12a)

11(11a)

21

10

9

## FIG. 10A

## FIG. 10B

FIG. 11A

145

1
50
5
11C
5A
5B

11D

3 (13)
4 (11)

11B
11B
2 (13)
5A
5B

7

13
11D

6

11C

145

12
12c
12b
12a
13

2 (13)
12

3 (13)
4

22
11

10

9

11c
11b
11a
8

11
7

FIG. 11C

13  12(b)

22

11(11b)

12

10

9

8

7  9  10

FIG. 11D

12(12a)

22

11(11a)

10

9

EP 2 924 402 A1

# FIG. 12A

# FIG. 12B

30

FIG. 13A

FIG. 13B

**FIG. 13C**

23
13
12(12b)
12
11(11b)
10
9
8
7    9    10

**FIG. 13D**

23
12(12a)
11(11a)
10
9

# FIG. 14

## INTERNATIONAL SEARCH REPORT

| | International application No. |
|---|---|
| | PCT/JP2013/006479 |

| A. CLASSIFICATION OF SUBJECT MATTER |
|---|
| *G01J1/02*(2006.01)i, *H01L37/02*(2006.01)i |

According to International Patent Classification (IPC) or to both national classification and IPC

| B. FIELDS SEARCHED |
|---|
| Minimum documentation searched (classification system followed by classification symbols) |
| G01J1/02, G01J1/42, G01J5/02, G01J5/34, G01K7/00, H01L21/8246, H01L27/105, H01L31/00-31/0232, H01L31/08-31/09, H01L37/00-37/02, H01L41/00-41/47 |

| Documentation searched other than minimum documentation to the extent that such documents are included in the fields searched |
|---|
| Jitsuyo Shinan Koho        1922-1996    Jitsuyo Shinan Toroku Koho    1996-2014 |
| Kokai Jitsuyo Shinan Koho  1971-2014    Toroku Jitsuyo Shinan Koho    1994-2014 |

| Electronic data base consulted during the international search (name of data base and, where practicable, search terms used) |
|---|
| |

| C. DOCUMENTS CONSIDERED TO BE RELEVANT | | |
|---|---|---|
| Category* | Citation of document, with indication, where appropriate, of the relevant passages | Relevant to claim No. |
| X | JP 2001-033307 A  (Matsushita Electric Industrial Co., Ltd.), 09 February 2001 (09.02.2001), paragraphs [0016] to [0031]; fig. 1 (Family: none) | 1,19 |
| Y | WO 2012/144185 A1  (Panasonic Corp.), 26 October 2012 (26.10.2012), paragraphs [0015] to [0070]; fig. 1 to 5 | 1-11,13-18 |
| Y | paragraph [0006] (Family: none) | 12 |
| Y | WO 2004/051760 A1  (Matsushita Electric Industrial Co., Ltd.), 17 June 2004 (17.06.2004), entire text; fig. 1 to 16 & US 2005/0087689 A1     & EP 1569284 A1 | 1-18 |

| ☒ | Further documents are listed in the continuation of Box C. | ☐ | See patent family annex. |
|---|---|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 27 January, 2014 (27.01.14) | 10 February, 2014 (10.02.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2013/006479

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2009-255529 A  (Seiko Epson Corp.),<br>05 November 2009 (05.11.2009),<br>paragraph [0042]; fig. 3<br>& US 2009/0244209 A1 | 6-7 |
| Y | JP 08-078735 A  (Matsushita Electric Industrial Co., Ltd.),<br>22 March 1996 (22.03.1996),<br>entire text; fig. 1 to 6<br>(Family: none) | 10-11 |
| Y | JP 2007-228190 A  (Matsushita Electric Works, Ltd.),<br>06 September 2007 (06.09.2007),<br>paragraphs [0015] to [0021]; fig. 1<br>(Family: none) | 13-14 |
| Y | JP 07-234159 A  (Matsushita Electric Works, Ltd.),<br>05 September 1995 (05.09.1995),<br>paragraph [0018]; fig. 3<br>(Family: none) | 15 |

Form PCT/ISA/210 (continuation of second sheet) (July 2009)

## INTERNATIONAL SEARCH REPORT

| International application No. |
| --- |
| PCT/JP2013/006479 |

**Box No. II**      **Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III**      **Observations where unity of invention is lacking (Continuation of item 3 of first sheet)**

This International Searching Authority found multiple inventions in this international application, as follows:
(See extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
     ☐ The additional search fees were accompanied by the applicant's protest and, where applicable, the payment of a protest fee.

     ☐ The additional search fees were accompanied by the applicant's protest but the applicable protest fee was not paid within the time limit specified in the invitation.

     ☐ No protest accompanied the payment of additional search fees.

Form PCT/ISA/210 (continuation of first sheet (2)) (July 2009)

**INTERNATIONAL SEARCH REPORT**

International application No.

PCT/JP2013/006479

Continuation of Box No.III of continuation of first sheet(2)

Document 1 (JP 2001-033307 A (Matsushita Electric Industrial Co., Ltd.), 09 February 2001 (09.02.2001), paragraphs [0016] to [0031]; fig. 1) discloses "an infrared detection element provided with: a substrate having a recessed portion; a first electrode provided from one end side portion and the other end side portion to the recessed portion on the upper surface of the substrate; a thin-film pyroelectric body provided above the recessed portion of the substrate on the upper surface of the first electrode; and a second electrode provided so as to be electrically connected with the thin-film pyroelectric body and electrically connected with the first electrode provided at the other end of the substrate, the thin-film pyroelectric body being formed from a lead titanate-based ferroelectric material, and the substrate being formed from (100) magnesium having a larger thermal expansion coefficient than the thin-film ferroelectric body in order to enhance the growth of the thin-film pyroelectric body as an oriented thin film".

Consequently, the invention of claim 1 is not considered to be novel in the light of the invention disclosed in the document 1, and therefore, it cannot be considered that said invention has a special technical feature.

Therefore, multiple invention groups are involved in claims.

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011001585 A
- WO 2004079311 A
- JP 2010540915 PCT